Europäisches Patentamt

(19) European Patent Office

Office européen des brevets

(11) Numéro de publication: **0 172 757**

**A1**

(12) # DEMANDE DE BREVET EUROPEEN

(21) Numéro de dépôt: **85400638.4**

(51) Int. Cl.⁴: **G 11 C 19/08**

(22) Date de dépôt: **01.04.85**

(30) Priorité: **05.04.84 FR 8405378**

(43) Date de publication de la demande:
**26.02.86 Bulletin 86/9**

(84) Etats contractants désignés:
**DE GB NL**

(71) Demandeur: **COMMISSARIAT A L'ENERGIE ATOMIQUE Etablissement de Caractère Scientifique Technique et Industriel**
**31/33, rue de la Fédération**
**F-75015 Paris(FR)**

(72) Inventeur: **Fedeli, Jean-Marc**
**3, rue Bach Le Fontanil Cornillon**
**F-38120 Saint Egreve(FR)**

(72) Inventeur: **Magnin, Joel**
**3, rue Doyen Gosse**
**F-38400 Saint Martin d'Heres(FR)**

(74) Mandataire: **Mongrédien, André et al,**
**c/o BREVATOME 25, rue de Ponthieu**
**F-75008 Paris(FR)**

(54) Duplicateur dans une mémoire à bulles à motifs non implantés, et mémoire comportant au moins un desdits duplicateurs.

(57) Duplicateur dans une mémoire à bulles magnétiques à motifs non-implantés, procédé pour la mise en oeuvre dudit duplicateur et mémoire à bulles magnétiques de type série-parallèle comportant au moins un desdits duplicateurs.

Dans une mémoire à bulles magnétiques comportant un premier ensemble (2) de motifs non-implantés alignés et un second ensemble (4) de motifs non-implantés alignés, le duplicateur de l'invention se caractérise en ce qu'il comprend un conducteur d'extension (6) et un conducteur de coupure (8), le conducteur d'extension reliant lesdits ensembles de motifs, le conducteur de coupure étant disposé transversalement audit conducteur d'extension, la géométrie du motif d'extrémité (16) du premier ensemble de motifs étant telle que la position de duplication est une position stable du premier ensemble de motifs et que la position de réception de la bulle dupliquée est une position stable du second ensemble de motifs.

FIG.3

DUPLICATEUR DANS UNE MEMOIRE A BULLES A MOTIFS
NON IMPLANTES, PROCEDE POUR LA MISE EN OEUVRE
DUDIT DUPLICATEUR ET MEMOIRE A BULLES DE TYPE
SERIE PARALLELE COMPORTANT AU MOINS UN DESDITS
DUPLICATEURS.

La présente invention a pour objet un duplicateur dans une mémoire à bulles magnétiques à motifs non implantés et un procédé pour la mise en oeuvre dudit duplicateur. Elle a aussi pour objet une mémoire à bulles magnétiques comportant au moins un duplicateur selon l'invention.

L'invention s'applique notamment à la mémorisation d'informations binaires ou bits, matérialisés sous la forme de domaines magnétiques isolés, qualifiés de bulles ; ces domaines généralement cylindriques, présentent une aimantation inverse de celle du reste du matériau magnétique (grenat) constituant la couche dans laquelle ces domaines sont formés. Dans cette mémoire, la duplication de bulles magnétiques permet notamment d'effectuer la duplication d'élément binaire par élément binaire ou la duplication par bloc d'éléments binaires.

Dans une couche magnétique monocristallin telle qu'un film de grenat magnétique, supporté par un grenat monocristallin amagnétique, les domaines ou bulles magnétiques sont stables par application d'un champ magnétique continu Hp perpendiculaire au plan de la couche magnétique. Dans la pratique, ce champ magnétique est créé par un aimant permanent assurant ainsi la non volatilité des informations contenues dans la mémoire.

Dans une mémoire à bulles magnétiques, le déplacement des bulles est réalisé en appliquant un champ continu tournant $H_T$ suivant une direction paral-

lèle à la surface de la couche magnétique. Le déplacement des bulles se fait autour de motifs dits de propagation, définis dans la partie supérieure de la couche magnétique.

Ces motifs présentant la forme de disques, de losanges, de triangles, de T etc... peuvent être réalisés en un matériau à base de fer et de nickel, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus ; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. Ces cavités constituent des positions dites stables. On réalise ainsi des registres à décalage dans lesquels l'information binaire "1" est représentée par la présence d'une bulle et l'information binaire "0" par l'absence d'une bulle.

En plus de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

Un des principaux types de mémoire à bulles magnétiques connu comprend un ensemble de boucles, ou registres, dites mineures servant au stockage des in-

B 8207.3   BL

formations, associé à une ou deux boucles, ou registres, dites majeures, constituant les stations d'accès à la mémoire. Les boucles mineures sont disposées longitudinalement, les unes à côté des autres et les boucles majeures sont orientées perpendiculairement aux boucles mineures. Les bulles magnétiques se trouvant dans les boucles mineures peuvent être transférées dans les boucles majeures et réciproquement, par l'intermédiaire de portes de transfert unidirectionnelles ou bidirectionnelles.

Lorsque l'on utilise une seule boucle majeure, la lecture et l'écriture des informations se font au moyen de cette unique boucle. Dans ce premier cas, on parle d'une mémoire présentant une organisation majeure mineure. En revanche, lorsque l'on utilise deux boucles majeures, l'écriture des informations se fait par l'intermédiaire de l'une de ces deux boucles et la lecture des informations par l'intermédiaire de l'autre boucle. Ces boucles majeures sont généralement situées de part et d'autre des boucles mineures. Dans ce dernier cas (deux boucles), on parle généralement d'une mémoire présentant une organisation série-parallèle.

Dans les mémoires à bulles décrites ci-dessus, la fabrication d'une bulle sur une boucle majeure, correspondant à l'écriture d'une information, est réalisée en appliquant un courant élevé à un conducteur, généralement en forme de U, traversant les motifs de propagation constituant la boucle majeure.Cette opération généralement connue sous le nom de nucléation est réalisée lorsque la bulle est dans une cavité définie entre deux motifs adjacents.

Après nucléation, la bulle est ensuite propagée, par application du champ tournant $H_T$, sur la boucle majeure vers les portes de transfert afin de

transférer la bulle de la boucle majeure vers une boucle mineure. Ces portes de transfert sont généralement réalisées par un conducteur en forme de U traversant les motifs constituant la boucle mineure. L'application d'une impulsion de courant à ce conducteur permet d'étendre chaque bulle entre les sommets des motifs de propagation de la boucle majeure et ceux correspondants de la boucle mineure et ensuite, l'arrêt de l'impulsion de courant entraîne la contraction des bulles sur la boucle mineure. Le transfert est alors réalisé. L'information est ainsi stockée sur la boucle mineure.

La lecture de cette information se fait en transférant une bulle magnétique d'une boucle mineure vers une boucle majeure. Cette lecture est destructive. La bulle magnétique est transférée sur un chemin de détection de la boucle majeure pour être détectée de manière destructive par un détecteur magnéto-résistif, généralement à base de fer et de nickel. Pour ne pas perdre l'information lors de la lecture, il est donc nécessaire de dupliquer la bulle magnétique. La bulle fille pourra être alors transférée vers le détecteur magnéto-résistif et la bulle mère sera réinjectée à la place occupée par la bulle d'origine dans la boucle mineure.

Une méthode de duplication a été décrite dans le brevet américain n° 4253159, déposé le 3 décembre 1979 et intitulé "Ion implanted bubble memory with replicate port". Dans ce brevet, on utilise une seule boucle majeure et des motifs de propagation non implantés.

Selon ce brevet, une bulle magnétique est transférée d'une boucle mineure vers la boucle majeure. La duplication est ensuite réalisée, sur la boucle majeure, au moyen d'un conducteur la traversant auquel

on applique une impulsion de courant, ceci entraînant l'élongation de la bulle de part et d'autre des deux chemins de propagation parallèles formés par les deux côtés de la boucle majeure puis la coupure de cette bulle en deux. L'une de ces bulles est alors transférée sur un chemin de détection vers le détecteur magnéto-résistif et l'autre bulle est réinjectée dans la boucle mineure à la place occupée par la bulle d'origine.

Une mémoire à bulles magnétiques comportant comme motif de propagation des motifs non implantés et présentant une structure et un fonctionnement tels que décrits dans ce brevet américain ne permet d'effectuer qu'une duplication des bulles correspondant à une duplication d'élément binaire par élément binaire. Ces mémoires ne permettent pas d'effectuer la duplication d'un ensemble ou bloc d'éléments binaires.

Cette méthode de lecture présente au moins deux inconvénients. Le premier inconvénient tient au fait que la lecture d'une information requiert outre la duplication de la bulle à lire le transfert de cette bulle de la boucle mineure à la boucle majeure puis la réinjection, après duplication, de la bulle dans la boucle mineure à la place qu'elle occupait précédemment. Par ailleurs, pour que la duplication se fasse correctement, il faut que l'impulsion de courant appliquée au conducteur d'extension ait lieu à un instant très précis par rapport à la phase du champ tournant $H_T$. La marge de phase sur cette impulsion de courant est très faible.

On connaît également un autre mode de réalisation d'un duplicateur mettant en oeuvre la même méthode de duplication. Une bulle à dupliquer est d'abord transférée d'une boucle mineure vers la boucle majeure. Elle est ensuite dupliquée entre cette boucle majeure et un autre chemin de propagation. Cette duplication est réalisée par deux conducteurs : un conducteur d'extension disposé entre la boucle majeure et l'autre chemin de propagation et un conducteur de coupure perpendiculaire au conducteur d'extension. La bulle restant sur la boucle majeure est envoyée vers le détecteur et la bulle créée par duplication sur l'autre chemin de propagation est renvoyée dans la boucle mineure.

Comme dans le brevet américain cité, cette méthode de duplication ne semble pas permettre simplement la duplication par bloc d'éléments binaires entre des boucles mineures et la boucle majeure de lecture. De plus, la marge de phase entre les impulsions de courant d'extension et de coupure et le champ tournant $H_T$ reste très faible, de l'ordre de 90 ns, ce qui rend cette duplication délicate en pratique.

On connaît également des mémoires à bulles magnétiques à motifs non implantés dont la structure permet une duplication par bloc d'éléments binaires.

L'article "Design and characteristics of 4µm period ion-implanted bubble devices with major line block replicate gate" publié dans IEEE TRANS ON MAGNETICS, vol. MAG-19, N°5, September 1983 décrit une telle mémoire à motifs non-implantés dans laquelle des motifs en fer-nickel sont disposés entre chaque boucle mineure et une boucle majeure. La lecture se fait en trois étapes :
- transfert de la bulle sur la boucle mineure vers un motif en fer-nickel,
- duplication par application d'une impulsion de courant dans un conducteur recouvrant le motif en fer-nickel,
- transfert d'une bulle vers la boucle majeure et réinjection de l'autre bulle dans la boucle mineure.

Une mémoire présentant une structure et un fonctionnement tels que décrits dans cet article présente l'inconvénient de nécessiter un double transfert de la bulle à lire. Il s'ajoute ici la complexité de réalisation de la mémoire qui comporte des motifs non implantés et des motifs en fer-nickel.

L'article "Design of a block replicate gate for ion-implanted bubble devices" publié dans IEEE TRANS ON MAGNETICS, vol. MAG-18, n°6, november 1982 décrit une mémoire à bulles dans laquelle une bulle à lire est dupliquée directement sans qu'il soit nécessaire de la transférer avant et après la duplication. Un conducteur d'extension est disposé selon l'axe de la boucle mineure, entre l'extrémité de la boucle mineure et une position stable de la boucle majeure. Un moyen de coupure est en outre disposé perpendiculairement au conducteur entre la boucle mineure et la boucle majeure. Ce moyen de coupure est constitué, soit par un barreau paramagnétique réalisé en rendant amorphe localement le matériau par forte implantation ionique, soit par un motif non implanté.

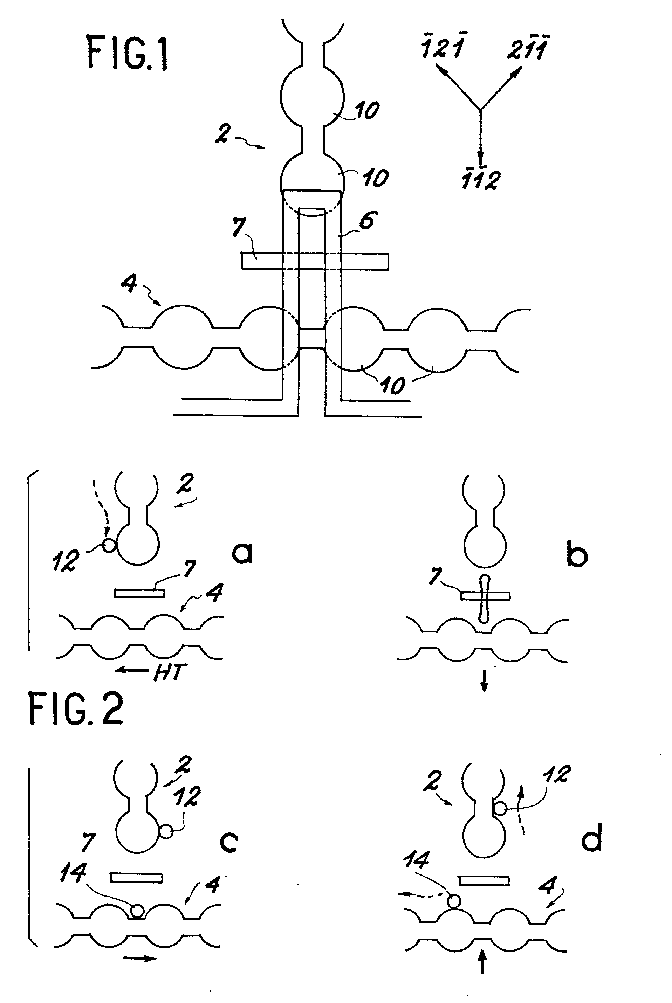

On a représenté sur la figure 1 un schéma illustrant la duplication dans une mémoire à bulles à motifs non implantés selon cette méthode.

Sur cette figure, sont représentés une boucle mineure 2, la boucle majeure 4, un conducteur d'extension 6 et un moyen de coupure 7. La boucle mineure 2 est constituée par une succession de motifs non-implantés 10 alignés suivant un axe de facile aimantation $\overline{112}$. La boucle majeure 4 est constituée par des motifs non implantés 10 identiques alignés suivant une direction perpendiculaire à l'axe de la boucle mineure 2. Ces motifs non implantés sont réalisés dans une couche d'un matériau magnétique. Le conducteur d'extension 6 est alors réalisé au-dessus de cette couche.

Ce conducteur d'extension 6 est en général en forme de U et est centré sur l'axe de la boucle mineure 2. La base de ce conducteur d'extension 6 est disposée à proximité de l'extrémité de la boucle mineure 2 et s'étend jusqu'à la boucle majeure 4. Le moyen de coupure 7 est, soit un rectangle, soit en forme de V. Il est centré sur l'axe du conducteur d'extension 6.

La duplication d'une bulle de la boucle mineure 2 se fait par application d'une impulsion sur le conducteur d'extension 6 lorsque ladite bulle se trouve à l'extrémité de la boucle mineure 2 à la base du conducteur 6. Cette impulsion de courant étend la bulle jusqu'à la boucle majeure 4. La coupure de cette bulle est favorisée par le moyen de coupure 7 dont la présence crée un champ magnétique.

La bulle se trouvant sur la boucle mineure est ainsi dupliquée sans qu'il soit nécessaire de la transférer.

Cependant, il est nécessaire d'appliquer une impulsion de contraction sur le conducteur d'extension 6 lorsque la bulle est étendue pour que la coupure se fasse. La durée de cette impulsion doit être inférieure à environ 50 ns pour éviter la destruction des bulles. Cette faible durée est difficilement réalisable du point de vue électronique.

Le déplacement de la bulle avec le champ tournant va être détaillé en référence aux figures 2a à 2d. Sur ces figures, le conducteur d'extension n'est pas représenté. Sur chacune de ces figures, on a représenté en correspondance la boucle mineure et la boucle majeure ainsi que la phase du champ tournant $H_T$, repérée par une flèche.

Sur la figure 2a, la bulle 12 se trouve pratiquement à l'extrémité de la boucle mineure 2. Sur la

B 8207.3 BL

figure 2b, elle a atteint cette extrémité et elle est étendue par application d'une impulsion de courant dans le conducteur d'extension. La présence du moyen de coupure favorise la coupure de la bulle et, grâce à une impulsion de contraction dans le conducteur d'extension, la bulle est enfin dupliquée. Les figures 2c et 2d illustrent le mouvement de la bulle originale 12 sur la boucle mineure 2 et de la bulle dupliquée 14 sur la boucle majeure 4.

On sait que les positions stables de la bulle, c'est-à-dire les positions dans lesquelles la bulle peut rester immobile pendant une grande partie (par exemple supérieure à T/2) de la période T du champ tournant $H_T$, sont constituées par les cavités situées à la jonction de deux motifs non implantés consécutifs. Entre deux cavités successives, la bulle se déplace continûment sous l'action du champ tournant $H_T$. La bulle 12 de la boucle mineure 2 est donc dans une position non stable lorsqu'elle est étendue et coupée comme représenté sur la figure 2b. Les impulsions de courant d'extension et de contraction doivent donc être très courtes et très bien synchronisées pour que la duplication se fasse correctement. L'erreur de phase sur ces deux impulsions par rapport au champ tournant $H_T$ est donc très faible.

L'invention a précisément pour but un duplicateur comprenant un conducteur d'extension et un conducteur de coupure pour une mémoire à bulles magnétiques à motifs non implantés dans laquelle les contraintes de phase sur les impulsions d'extension et de coupure sont moins importantes. De plus, la coupure de la bulle est réalisée de manière indépendante de l'extension, ce qui permet un meilleur contrôle de la duplication. Ceci a pour conséquence une amélioration de la fiabilité de la duplication qui est opérée dans de meilleures conditions.

De manière précise, l'invention a pour objet un duplicateur dans une mémoire à bulles magnétiques comportant une couche de matériau magnétique dans laquelle des bulles magnétiques peuvent être déplacées par application d'un champ tournant $H_T$ selon un premier et un second chemins de propagation, ledit premier chemin étant défini par un premier ensemble de motifs non implantés alignés suivant un axe cristallographique plan de facile aimantation du matériau magnétique, ledit second chemin étant défini par un second ensemble de motifs non implantés alignés suivant un axe transversal à l'axe du premier ensemble de motifs, ledit duplicateur étant caractérisé en ce qu'un conducteur d'extension est disposé entre le motif d'extrémité du premier ensemble de motifs et le second ensemble de motifs, en ce qu'un conducteur de coupure est disposé transversalement audit conducteur d'extension entre les deux ensembles de motifs, en ce que la géométrie du motif d'extrémité du premier ensemble de motifs est telle que la position de duplication sur le premier chemin de propagation est une position stable et en ce que la position de réception de la bulle dupliquée sur le second chemin de propagation est une position stable.

Ce duplicateur peut être utilisé pour la duplication d'une bulle magnétique entre deux chemins de propagation quelconques d'une mémoire à bulles. Les chemins peuvent être notamment une boucle mineure et la boucle majeure de lecture.

Selon une caractéristique du duplicateur selon l'invention, une zone implantée est réalisée dans le motif d'extrémité en regard du second ensemble de motifs.

Selon une autre caractéristique du duplicateur selon l'invention, une zone implantée est en outre réalisée dans le centre du motif d'extrémité et un intervalle implanté, centré sur l'axe du premier en-

semble de motifs, relie lesdites zones implantées.

Selon une autre caractéristique du duplicateur selon l'invention, un intervalle implanté est réalisé entre deux motifs du second ensemble de motifs dans l'axe du conducteur d'extension.

Cet intervalle implanté constitue un élément réunion.

L'invention a également pour objet un procédé de duplication dans lequel on applique une impulsion de courant au conducteur d'extension et une impulsion de courant au conducteur de coupure, l'impulsion d'extension débutant avant l'impulsion de coupure, et dans lequel l'impulsion d'extension coïncide en phase et en durée avec le moment où une bulle est immobile dans la position de duplication.

Selon une caractéristique du procédé de duplication selon l'invention, l'impulsion de coupure débute avant la fin de l'impulsion d'extension.

Selon une autre caractéristique du procédé de duplication selon l'invention, l'impulsion de coupure se termine avant la fin de l'impulsion d'extension.

L'invention a enfin pour objet une mémoire à bulles magnétiques à motifs non-implantés comprenant :

- une pluralité de premiers ensembles de motifs non implantés, dits boucles mineures, alignés suivant un axe cristallographique plan de facile aimantation du matériau magnétique,

- un deuxième ensemble de motifs non implantés, dit boucle majeure d'écriture, disposé perpendiculairement aux boucles mineures,

- un moyen de génération des bulles sur ladite boucle d'écriture,

- un moyen pour transférer en bloc un élément binaire de la boucle d'écriture dans chaque boucle mineure,

- un troisième ensemble de motifs non implantés, dit boucle majeure de lecture, disposé perpendiculairement aux boucles mineures,

- un moyen de détection des bulles sur ladite boucle de lecture,

- et un moyen de duplication, conforme à l'invention pour dupliquer en bloc un élément binaire de chaque boucle mineure dans la boucle de lecture.

Les caractéristiques et avantages de l'invention ressortiront mieux de la description qui va suivre, donnée à titre illustratif mais non limitatif, en référence aux dessins annexés, sur lesquels :

- les figures 1, 2a à 2d illustrent la duplication, selon l'art connu, d'une bulle magnétique dans une mémoire à bulles à motifs non implantés,

- la figure 3 est un schéma d'une extrémité d'une boucle mineure, d'une boucle majeure et des conducteurs d'extension et de coupure réalisant un duplicateur selon l'invention,

- les figures 4a à 4h illustrent le fonctionnement du duplicateur de la figure 3,

- la figure 5 est un chronogramme des impulsions de courant d'extension et de coupure pour la duplication d'une bulle magnétique au moyen du duplicateur de l'invention,

- la figure 6 est une variante de réalisation du motif d'extrémité de la boucle mineure,

- la figure 7 est un dessin schématique de la structure d'une mémoire à bulles à motifs non-implantés de type série-parallèle dont les duplicateurs comportent deux conducteurs.

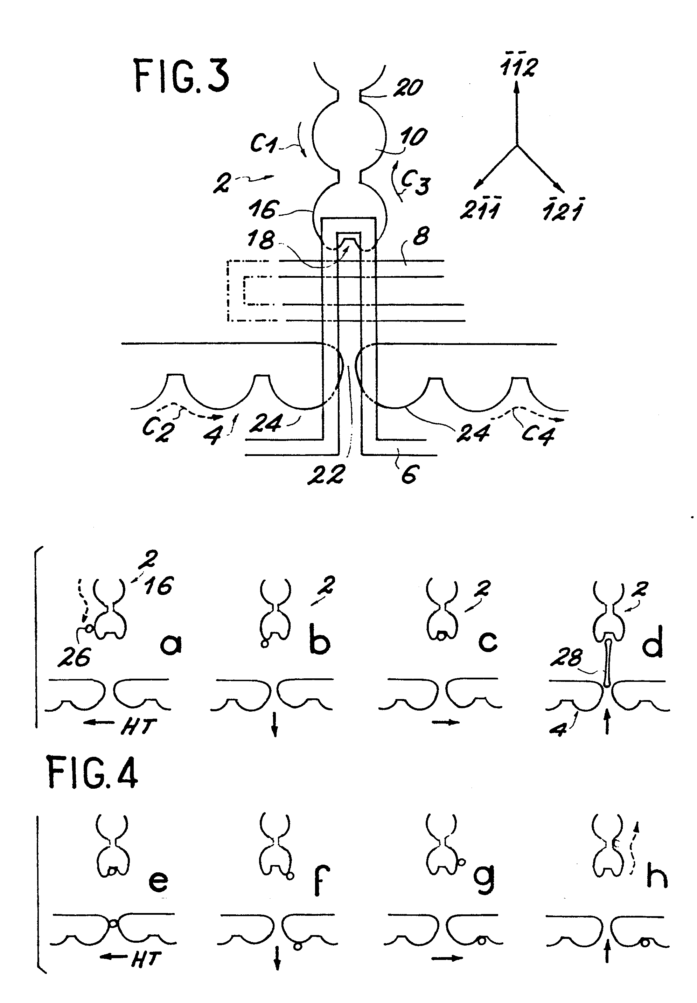

On a représenté sur la figure 3 une boucle mineure 2 dont les motifs sont alignés suivant un axe de facile aimantation TI2, une boucle majeure 4, un conducteur d'extension 6 et un conducteur de coupure 8.

Le conducteur d'extension 6, par exemple en forme de U, est centré sur l'axe de la boucle mineure

2. Une de ces extrémités recouvre le motif d'extrémité 16 de la boucle mineure 2. Il traverse par ailleurs la boucle majeure 4. Le conducteur de coupure 8 est sécant avec le conducteur d'extension 6. Il est en général perpendiculaire à ce dernier.

Selon l'invention, le motif non-implanté d'extrémité 16 de la boucle mineure 2 présente une géométrie telle que la position de duplication d'une bulle soit une position stable.

Dans le cas de la figure, ceci est réalisé par une zone implantée 18 dans la partie du motif d'extrémité 16 disposé en regard de la boucle majeure 4. Grâce à cette géométrie particulière, la position de duplication est une position aussi stable que les cavités 20 qui se trouvent à la jonction de deux motifs non-implantés consécutifs.

Pour bénéficier pleinement du gain de temps procuré par le fait que la position de duplication est une position stable, il faut également que la position correspondante sur la boucle majeure soit une position stable. Ceci est obtenu par la création d'un intervalle implanté 22 entre deux motifs non-implantés 24 de la boucle majeure 4. Cet intervalle (en anglais "gap") permet de manière connue de réunir deux chemins de propagation qui sont ici les chemins C1 représentés par une flèche pointillée le long de la boucle mineure 2 et le chemin C2 représenté par une flèche pointillée le long de la boucle majeure 4.

La boucle majeure 4 est une boucle de lecture. Les bulles dupliquées de la boucle mineure 2 ou les bulles provenant du chemin C2 de la boucle majeure 4 sont transférées par le chemin de propagation C4 vers un détecteur (non représenté), par exemple un détecteur magnéto-résistif.

On va maintenant décrire en référence aux figures 4a à 4h la duplication d'une bulle de la boucle mineure. Sur chacune de ces figures, on a repré-

B 8207.3  BL

senté la position de la bulle magnétique en fonction de la phase du champ tournant $H_T$ représenté par une flèche.

Sur les figures 4a et 4b, la bulle magnétique 26 se déplace le long du motif d'extrémité 16 de la boucle mineure 2. Sur les figures 4c, 4d et 4e, la bulle est immobile dans la position de duplication constituée par la zone implantée 18 du motif d'extrémité 16.

Pendant que la bulle est en position stable, une impulsion de courant est appliquée au conducteur d'extension (non représenté) pour étendre la bulle entre la boucle mineure 2 et la boucle majeure 4. Cette bulle étendue porte la référence 28 sur la figure 4d. Pendant que la bulle est étendue, une impulsion de courant est appliquée sur le conducteur de coupure (non représenté) pour scinder la bulle étendue 28, ce qui réalise la duplication telle que représentée sur la figure 4e.

Chacune des deux bulles magnétiques -la bulle mère sur la boucle mineure 2 et la bulle fille sur la boucle majeure 4- se déplacent ensuite en fonction de la phase du champ tournant $H_T$ comme représenté sur les figures 4f, 4g et 4h.

La stabilité de la bulle magnétique dans la position de duplication sur la boucle mineure permet d'avoir une bien meilleure marge de phase pour les impulsions d'extension et de coupure, par rapport à la phase du champ tournant $H_T$, que dans les dispositifs connus.

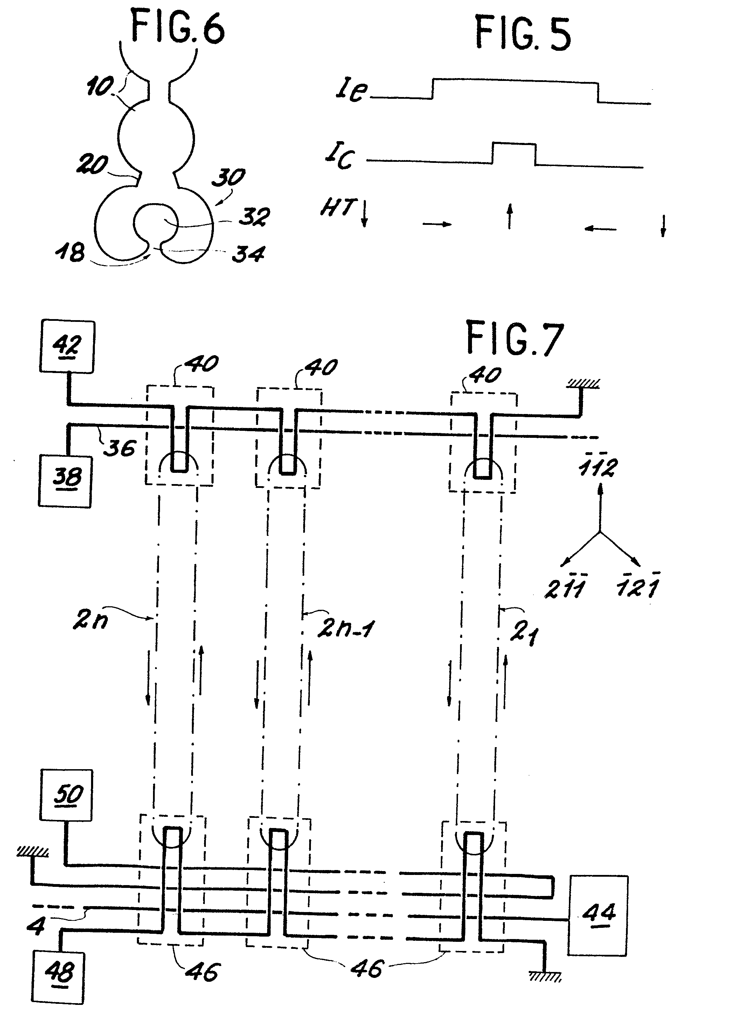

On a représenté sur la figure 5 un chronogramme illustrant les impulsions de courant d'extension Ie et de coupure Ic en fonction de la phase du champ tournant $H_T$. Sur cette figure, la phase du champ tournant $H_T$ est représentée par une flèche qui a la

B 8207.3  BL

0172757

même signification que sur la figure 4.

L'impulsion d'extension Ie est présente pendant toute la durée de stabilité de la bulle dans la position de duplication. Ceci n'est cependant pas impératif et la largeur de l'impulsion d'extension Ie pourrait être réduite sans inconvénient. Toutefois, de préférence, cette impulsion d'extension Ie est centrée sur l'instant où la phase du champ tournant $H_T$ est nulle (figure 4d).

Selon l'invention, l'impulsion de coupure Ic débute pendant que le conducteur d'extension est activé. De préférence, cette impulsion de coupure se termine avant la fin de l'impulsion d'extension. Cette impulsion est de préférence présente lorsque la phase du champ tournant $H_T$ est nulle (figure 4d).

Ainsi, grâce à la stabilité de la position de duplication de la boucle mineure, les impulsions de courant Ie et Ic peuvent être déclenchées avec une latitude de phase importante par rapport à la phase du champ tournant $H_T$. Ceci permet une duplication plus facile et plus fiable.

On sait qu'une impulsion de courant de grande amplitude dans le conducteur d'extension est susceptible d'entraîner la nucléation d'une bulle dans la position de duplication du motif d'extrémité 16 de la boucle mineure représentée sur la figure 3. On a représenté sur la figure 6 une variante de réalisation de ce motif d'extrémité permettant d'obtenir de meilleures marges de fonctionnement en amplitude d'impulsion.

La forme de ce motif d'extrémité 30 rend plus difficile la nucléation d'une bulle dans la position de duplication constituée par la zone implantée 18. Ce motif d'extrémité 30 présente une zone implantée centrale 32 et un intervalle implanté 34 reliant

B 8207.3 BL

ladite zone implantée centrale 32 à la zone implantée 18. Cet intervalle implanté 34, identique à l'intervalle implanté 22 réalisé entre deux motifs non implantés 24 de la boucle majeure 4 (figure 3), rend plus difficile la nucléation d'une bulle.

On a représenté sur la figure 7 un dessin schématique d'une mémoire à bulles dont les portes de duplication peuvent être avantageusement celles de l'invention.

Cette mémoire à bulles comprend de façon classique n boucles mineures $2_1$, $2_2$, ..., $2_n$ orientées selon un axe de facile aimantation $\overline{112}$ de la mémoire. Cette mémoire comprend également une boucle majeure d'écriture 36 qui est reliée à un moyen de génération des bulles 38. Des portes de transfert 40 constituées par exemple par un conducteur en U permettent de transférer une bulle de la boucle majeure 36 à une boucle mineure. Ces portes de transfert peuvent être reliées en série entre elles et permettre ainsi, grâce à l'application d'une impulsion de transfert par un générateur d'impulsion 42, de transférer simultanément une bulle de la boucle majeure 36 dans chacune des boucles mineures.

La mémoire comprend en outre une boucle majeure de lecture 4 qui est reliée à un détecteur 44, souvent de type magnéto-résistif. La lecture des bulles des boucles mineures se fait, ainsi qu'on l'a décrit précédemment, par l'intermédiaire de duplicateurs 46.

Chacun de ces duplicateurs comprend un conducteur d'extension 6, par exemple en forme de U, et un conducteur de coupure 8 disposé entre une boucle mineure et la boucle majeure de lecture 4 comme décrit en référence à la figure 3.

Les conducteurs de chacun de ces duplicateurs peuvent avantageusement être mis en série, ce qui permet de réaliser, par l'intermédiaire d'un générateur d'impulsion d'extension 48 et d'un générateur d'impulsion de coupure 50, la duplication simultanée de chaque bulle en position de duplication de la boucle mineure dans la boucle majeure de lecture 4.

B 8207.3  BL

0172757

REVENDICATIONS

1. Duplicateur dans une mémoire à bulles magnétiques comportant une couche de matériau magnétique dans laquelle des bulles magnétiques peuvent être déplacées par application d'un champ tournant $H_T$ selon un premier et un second chemins de propagation, ledit premier chemin étant défini par un premier ensemble (2) de motifs non implantés alignés suivant un axe cristallographique plan de facile aimantation du matériau magnétique, ledit second chemin étant défini par un second ensemble (4) de motifs non implantés alignés suivant un axe transversal à l'axe du premier ensemble de motifs, ledit duplicateur étant caractérisé en ce qu'il comprend un conducteur d'extension (6) et un conducteur de coupure (8), le conducteur d'extension étant disposé entre le motif d'extrémité (16, 30) du premier ensemble de motifs et le second ensemble de motifs, le conducteur de coupure étant disposé trans-versalement audit conducteur d'extension entre les deux ensembles de motifs, et la géométrie du motif d'extrémité du premier ensemble de motifs étant telle que la position de duplication sur le premier chemin de propagation et la position de réception de la bulle dupliquée sur le second chemin de propagation sont des positions stables.

2. Duplicateur selon la revendication 1, carac-térisé en ce qu'une zone implantée (18) est réalisée dans le motif d'extrémité (16) en regard du second ensemble (4) de motifs non-implantés.

3. Duplicateur selon la revendication 2, carac-térisé en ce qu'en outre une zone implantée (32) centrale est réalisée dans le centre du motif d'extrémité et en ce qu'un intervalle implanté (34) centré sur l'axe du premier ensemble de motifs, relie lesdites zones implantées (18,32).

4. Duplicateur selon l'une quelconque des reven-dications 1 à 3, caractérisé en ce qu'un intervalle implanté (22) est réalisé entre deux motifs du second ensemble (4) de motifs dans l'axe du conducteur d'extension (6).

B 8207.3 BL

**0172757**

5. Procédé de duplication pour la mise en oeuvre du duplicateur selon l'une quelconque des revendications 1 à 4 dans lequel on applique une impulsion de courant au conducteur d'extension (6) et une impulsion de courant au conducteur de coupure (8), l'impulsion d'extension (Ie) débutant avant l'impulsion de coupure (Ic), ledit procédé étant caractérisé en ce que l'impulsion d'extension coïncide en phase et en durée avec le moment où une bulle est immobile dans la position de duplication.

6. Procédé de duplication selon la revendication 5, caractérisé en ce que l'impulsion de coupure (Ic) débute avant la fin de l'impulsion d'extension (Ie).

7. Procédé de duplication selon la revendication 6, caractérisé en ce que l'impulsion de coupure (Ic) se termine avant la fin de l'impulsion d'extension (Ie).

8. Mémoire à bulles magnétiques à motifs non implantés comprenant :
- une pluralité de premiers ensembles ($2_1$,..., $2_n$) de motifs non implantés, dits boucles mineures, alignés suivant un axe cristallographique plan de facile aimantation du matériau magnétique,
- un deuxième ensemble (36) de motifs non implantés, dit boucle majeure d'écriture, disposé perpendiculairement aux boucles mineures,
- un moyen (38) de génération des bulles sur ladite boucle d'écriture,
- des moyens (40, 42) pour transférer en bloc un élément binaire de la boucle d'écriture dans chaque boucle mineure,
- un troisième ensemble (4) de motifs non implantés, dit boucle majeure de lecture, disposé perpendiculairement aux boucles mineures,
- un détecteur (44) des bulles sur ladite boucle de lecture,
- et un moyen pour dupliquer en bloc un élément binaire de chaque boucle mineure dans la boucle de lecture, ladite mémoire à bulles étant caractérisée en ce que

B 8207.3 BL

**0172757**

ledit moyen de duplication comporte une pluralité de duplicateurs (46) conforme à l'une quelconque des revendications 1 à 4.

9. Mémoire à bulles magnétiques à motifs non implantés selon la revendication 8, caractérisé en ce que le moyen de duplication comprend des générateurs d'impulsion (48, 50) pour appliquer une impulsion de courant au conducteur d'extension (6) et une impulsion de courant au conducteur de coupure (8), l'impulsion d'extension (Ie) débutant avant l'impulsion de coupure (Ic) et coïncidant en phase et en durée avec le moment où une bulle est immobile dans la position de duplication.

B 8207.3 BL

FIG.1

0172757

FIG.2

FIG.3

FIG.4

0172757

3.3

# FIG.6

10
20
30
32
18
34

# FIG.5

$I_e$

$I_c$

$HT$ ↓    →    ↑    ←    ↓

# FIG.7

42

40   40   40

36

38

112

211   121

2n   2n-1   2₁

50

4

44

48   46   46

**Office européen
des brevets**

**RAPPORT DE RECHERCHE EUROPEENNE**

**0172757**
Numéro de la demande

EP 85 40 0638

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| A | EP-A-0 072 696 (FUJITSU LTD.)<br><br>* Page 5, ligne 32 - page 6, ligne 11; figure 4 * | 1,4,8, 9 | G 11 C 19/08 |
| A | RCA TECHNICAL NOTES, no. 885, 4 juin 1971, pages 1-3, Princeton, N.J., US; H.S. KURLANSIK et al.: "Bubble domain constructions"<br>* En entier * | 1,5,6 | |
| A | IEEE TRANSACTIONS ON MAGNETICS, vol. MAG-18, no. 6, novembre 1982, pages 1352-1354, IEEE, New York, US; K. KOMENOU et al.: "Design of a block replicate gate for ion-implanted bubble devices"<br>* Page 1352, colonne de droite, paragraphe: "Gate design" * | 1,4 | |
| A | EP-A-0 044 708 (FUJITSU)<br>* Page 15, ligne 31 - page 16, ligne 11; figure 19 * | 2-4 | DOMAINES TECHNIQUES RECHERCHES (Int. Cl.4)<br><br>G 11 C 19/08 |

Le présent rapport de recherche a été établi pour toutes les revendications

| Lieu de la recherche | Date d'achèvement de la recherche | Examinateur |
|---|---|---|
| LA HAYE | 20-09-1985 | DEGRAEVE G. |